Europäisches Patentamt

European Patent Office

Office européen des brevets

(19)

(11) Publication number: **0 083 208**
**B1**

## (12) EUROPEAN PATENT SPECIFICATION

(45) Date of publication of patent specification: **28.09.88**

(51) Int. Cl.⁴: **H 03 K 19/086**

(21) Application number: **82306889.5**

(22) Date of filing: **23.12.82**

(54) A bias circuit for an emitter coupled logic circuit.

(30) Priority: **29.12.81 JP 214807/81**

(43) Date of publication of application:
**06.07.83 Bulletin 83/27**

(45) Publication of the grant of the patent:
**28.09.88 Bulletin 88/39**

(84) Designated Contracting States:
**DE FR GB**

(56) References cited:
**DE-A-2 941 870**
**US-A-3 828 240**

**ELECTRICAL DESIGN NEWS, vol. 18, no. 14,
20th July 1973, pages 32-36, Denver, US; L.
MAUL: "Use ECL for your high-speed designs"**

(73) Proprietor: **FUJITSU LIMITED**
**1015, Kamikodanaka Nakahara-ku
Kawasaki-shi Kanagawa 211 (JP)**

(72) Inventor: **Kanai, Yasunori**
**536-5-2-401, Omaru
Inagi-shi Tokyo 206 (JP)**
Inventor: **Sugiyama, Eiji**
**208-10, Seki Tama-ku
Kawasaki-shi Kanagawa 214 (JP)**
Inventor: **Nawata, Katumasa**
**5-22-32-204, Nishiikuta Tama-ku
Kawasaki-shi Kanagawa 214 (JP)**

(74) Representative: **Fane, Christopher Robin King
et al
HASELTINE LAKE & CO. Hazlitt House
28 Southampton Buildings Chancery Lane
London, WC2A 1AT (GB)**

Courier Press, Leamington Spa, England.

# Description

The present invention relates to a bias circuit. More particularly, it relates to a bias circuit for an emitter coupled logic (ECL) circuit in a large scale integrated circuit (LSI).

Generally, in bipolar-type logic circuits such as ECL circuits, the delay time for one logic circuit stage depends largely on the amount of current flowing through the circuit. That is, the delay time in each circuit is nearly inversely proportional to the amount of current flowing therethrough so long as that the parasitic capacitances in the circuit, the wiring capacitances associated with the wires for connecting elements in the circuit, the switching capability of each transistor in the circuit, and the ratio of currents delivered to various elements in the circuit are constant. In other words, the greater the current supplied to the circuit, the higher the switching speed. Because of this, when trying to decrease the power consumption of integrated circuits, it is better to lower the power supply voltage rather than the current. Reduction of the power consumption of integrated circuits is necessary from the viewpoint of decreasing the amount of heat generated in the circuits, one of the factors limiting the degree of integration. The greater the power consumption in a circuit, the greater the amount of heat that is generated. The power consumption in each gate is especially great in conventional bipolar-type integrated circuits.

Two power supplies are generally used for an ECL integrated circuit, i.e., a power supply for applying to the circuit voltage between $-5.2$ V and $-4.5$ V and a power supply for providing a voltage of $-2$ V as a terminating voltage at the ends of signal lines. It is desirable to provide a bias circuit which can be operated at the voltage of $-2$ V, which is regularly used for the termination of signal lines in ECL circuit systems.

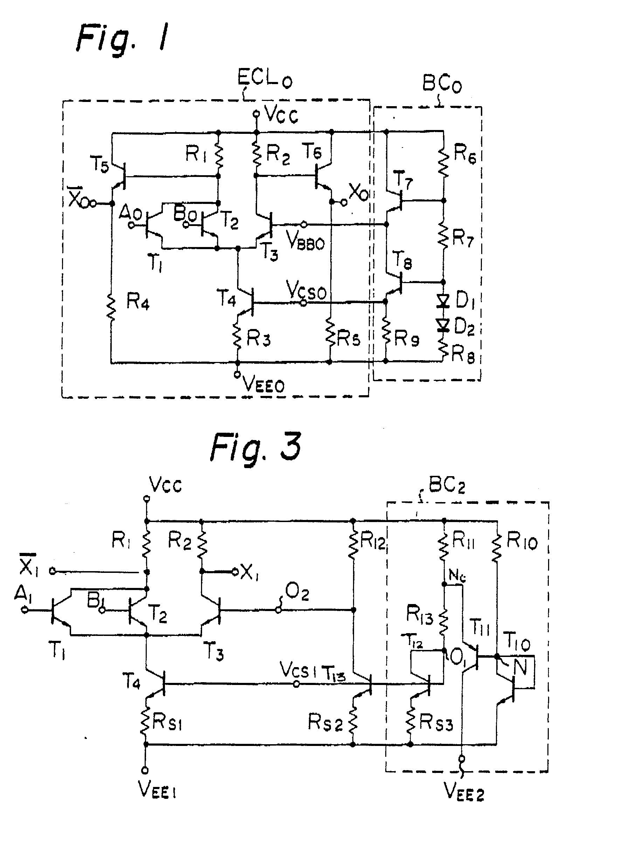

Figure 1 of the accompanying drawings is a diagram of a conventional bias circuit and a conventional ECL circuit to which a bias voltage is applied. In the figure, the ECL circuit $ECL_0$ comprises input transistors $T_1$ and $T_2$, a reference transistor $T_3$, a transistor $T_4$ functioning as a constant current course, an output transistor $T_5$ for outputting a logical NOR output $\overline{X}_0$, an output transitor $T_6$ for outputting a logical OR output $X_0$, load resistors $R_1$ and $R_2$, and resistors $R_3$, $R_4$, and $R_5$ for current feedback, connected to the emitters of the transistors $T_4$, $T_5$, and $T_6$, respectively. To the base of the reference transistor $T_3$, a first bias voltage $V_{BB0}$ output from a bias circuit $BC_0$ is applied. To the base of the transistor $T_4$, a second bias voltage $V_{CS0}$ output from the bias circuit $BC_0$ is applied.

The bias circuit $BC_0$ comprises resistors $R_6$ and $R_7$, diodes $D_1$ and $D_2$, and a resistor $R_8$, connected together in series between a first power supply terminal $V_{CC}$ and a second power supply terminal $V_{EE0}$. The bias circuit $BC_0$ also comprises transistors $T_7$ and $T_8$ and a resistor $R_9$ connected in series between the first power supply terminal

$V_{CC}$ and the second power supply terminal $V_{EE0}$. The base of the transistor $T_7$ is connected to a connecting point between the resistors $R_6$ and $R_7$. The base of the transistor $T_8$ is connected to a connecting point between the resistor $R_7$ and the diode $D_1$.

The first bias voltage $V_{BB0}$ is determined by the base-emitter voltage $V_{BET}$ of the transistor $T_7$, which is about 0.8 V, and the voltage drop across the resistor $R_6$, which is, for example, 0.5 V. Therefore, the voltage $V_{BB0}$ is about $-1.3$ V. Thie bias voltage $V_{BB0}$ is higher than a low level (L level) of, for example, $-1.7$ V and lower than a high level (H level) of, for example, $-0.9$ V.

The operation of the ECL circuit $ECL_0$ is well known. In brief, when at least one of the inputs $A_0$ and $B_0$ is at the H level, the transistor $T_1$ or $T_2$ is on, or both the transistors $T_1$ and $T_2$ are on, and the transistor $T_3$ is off, resulting, at the NOR output $\overline{X}_0$, in the L level of about $-1.7$ V, which is determined by the voltage drop (0.9 V) across the resistor $R_1$ and the base-emitter voltage (0.8 V) of the transistor $T_5$, and resulting, at the OR output $X_0$, in the H level of about $-0.9$ V which is determined by the base-emitter voltage (0.8 V) of the transistor $T_6$ and the voltage drop (0.1 V) across the resistor $R_2$. It will be seen that the L level voltage at the output $\overline{X}_0$ or $X_0$ is partially determined by the ratio of the resistors $R_1$ and $R_3$. When both of the inputs $A_0$ and $B_0$ are at the L level, the transistors $T_1$ and $T_2$ are both off, and the transistor $T_3$ is on, resulting in the H level at the NOR output $\overline{X}_0$ and resulting in the L level at the OR output $X_0$.

Generally, in an ECL circuit, the first power supply voltage (also referred to as $V_{CC}$) is 0 V, and the second power supply voltage (also referred to as $V_{EE0}$) is a negative voltage. In order to suppress the generation of heat in the ECL circuit, it is desirable to limit the voltage difference between $V_{CC}$ and $V_{EE0}$ as much as possible. However, when the conventional bias circuit $BC_0$ is employed, the minimum voltage difference between $V_{CC}$ and $V_{EE0}$ for a reliable operation is about 3 V, as explained in the following. That is, the voltage difference between $V_{CC}$ and $V_{EE0}$ is determined by the sum of the voltage drop across the resistor $R_6$, the base-emitter voltage of the transistor $T_7$, the base-collector voltage of the transistor $T_8$, the forward bias voltages across the diodes $D_1$ and $D_2$, and the voltage drop across the resistor $R_8$. The maximum collector-base voltage of the transistor $T_8$ for keeping its collector-base junction in a reverse bias state, in order to prevent the transistor $T_8$ from being operated in a saturation region, is 0 V. The base-emitter voltage of each transistor and the forward bias voltage of each diode, when manufactured from silicon, are both about 0.8 V. Therefore, the voltage difference between $V_{CC}$ and $V_{EE0}$ should be at least 2.4 V. In order to attain stable operation, the voltage drops across the resistors $R_6$ and $R_8$ should be, for example, about 0.2 V and 0.4 V, respectively. As a result, the above-mentioned sum is about 3 V. Therefore, the second power supply $V_{EE0}$ should be lower than −3 V. The absolute value of this voltage is too great for increased integration in an integrated circuit.

In the conventional circuit of Fig. 1, if the second power supply voltage $V_{EE0}$ is −2 V, the base-emitter voltage of the transistor $T_7$ and the forward bias voltage of the diodes $D_1$ and $D_2$ would become insufficient, thereby preventing operation of the bias circuit $BC_0$.

It is accordingly desirable to provide an improved bias circuit which can operate stably at a lower power supply voltage, and therefore with relatively low power consumption, without reducing the switching speed unacceptably. The heat generated in such a circuit would be relatively low, thus permitting a relatively high degree of integration in an integrated circuit device including such bias circuits.

According to the present invention there is provided a bias circuit, for producing a bias voltage output, comprising:

a first transistor, having a base connected to one end of a first resistive device, an emitter connected to a first reference-voltage line, and a collector connected to the said base; and

supply means connected to the other end of the said first resistive device, for maintaining the said other end at a substantially constant voltage, which supply means include a second resistive device having one end connected to the said other end of the said first resistive device and having its other end connected to a second reference-voltage line, a second transistor, having a base connected to a collector thereof and an emitter connected to the said first reference-voltage line, and a third resistive device having one end connected to the said collector of the second transistor and having its other end connected to the said second reference-voltage line, and also include an element having a forward-biased PN junction which is connected at one side to the said other end of the first resistive device and at its other side to the said collector of the second transistor;

the said bias voltage output being available at the said one end of the first resistive device when the circuit is in operation.

Reference will now be made, by way of example, to the accompanying drawings, in which:

Figure 1 is a diagram of a conventional bias circuit and a conventional ECL circuit to which a bias voltage is applied;

Fig. 2 is a diagram of a bias circuit and an ECL circuit to which a bias voltage is applied, according to an embodiment of the present invention;

Fig. 3 is a circuit diagram illustrating another embodiment of the present invention;

Fig. 4 is a block diagram of an example of a system employing conventional ECL circuits; and

Fig. 5 is a block diagram illustrating an ECL large-scale integrated circuit to which the present invention may be effectively applied.

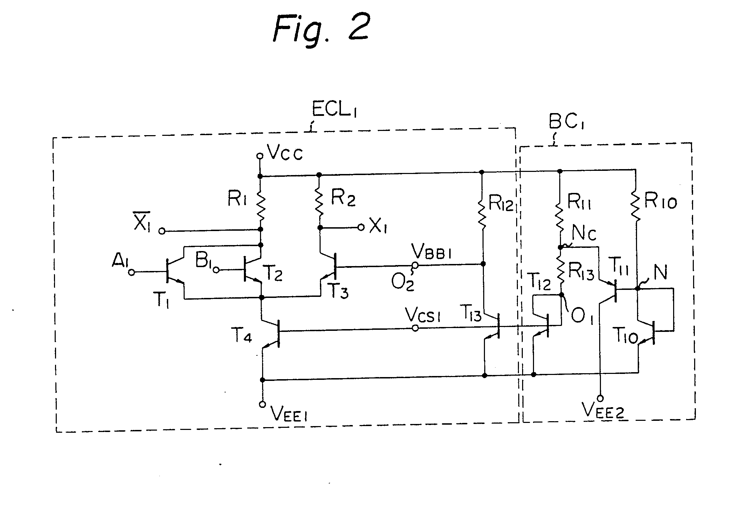

Figure 2 illustrates an ECL circuit $ECL_1$ which is similar to the circuit $ECL_0$ of Fig. 1 except that the

ECL circuit $ECL_1$ in Fig. 2 does not include the emitter follower output transistors $T_5$ and $T_6$, or the resistors $R_3$, $R_4$, and $R_5$, but includes an NPN transistor $T_{13}$ and a load resistor $R_{12}$. The resistance value of the load resistor $R_{12}$ is half that of the load resistor $R_1$ or $R_2$.

A bias circuit $BC_1$ in Fig. 2 is greatly different from the conventional bias circuit $BC_0$ in Fig. 1. The bias circuit $BC_1$ comprises an NPN transistor $T_{10}$, a PNP transistor $T_{11}$, NPN transistor $T_{12}$, load resistors $R_{10}$, and $R_{11}$, and a resistor $R_{13}$. The collector and the base of the NPN transistor $T_{10}$ are commonly connected to a node N. Between the node N and the first power supply terminal $V_{CC}$, the load resistor $R_{10}$ is connected. The emitter of the transistor $T_{10}$ is connected to a second power supply terminal $V_{EE1}$ to which a power supply voltage of −2 V, which is higher than the conventional power supply voltage of lower than −3 V, as described later in detail. The PNP transistor $T_{11}$ has a base connected to the node N, an emitter connected through the load resistor $R_{11}$ to the first power supply terminal $V_{CC}$, and a collector connected to a third power supply terminal $V_{EE2}$. The voltage at the third power supply terminal $V_{EE2}$ is equal to or lower than the voltage at the second power supply terminal $V_{EE1}$. The emitter of the PNP transistor $T_{11}$ is also connected at a node $N_C$ to one end of the resistor $R_{13}$. The other end of resistor $R_{13}$ is connected to a node $O_1$ to which the base and the collector of the NPN transistor $T_{12}$ are commonly connected. The emitter of the transistor $T_{12}$ is connected to the second power supply terminal $V_{EE1}$. The transistor $T_{13}$ has a collector connected through the load resistor $R_{12}$ to the first power supply terminal $V_{CC}$, a base connected to the node $O_1$, and an emitter connected to the second power supply terminal $V_{EE1}$. By the circuit configuration of this bias circuit $BC_1$, the voltage difference between the first power supply voltage, also referred to as $V_{CC}$, and the second power supply voltage, also referred to as $V_{EE1}$, is:

$$V_{CC} - V_{EE1} = V(R_{11}) + V_{EBT11} + V_{BET10},$$

where $V(R_{11})$ is the voltage drop across the resistor $R_{11}$; $V_{EBT11}$ is the emitter-base forward voltage of the PNP transistor $T_{11}$; and $V_{BET10}$ is the base-emitter forward voltage of the NPN transistor $T_{10}$. $V_{EBT11}$ and $V_{BET10}$ are both about 0.8 V. If the second power supply voltage $V_{EE1}$ is −2 V and the first power supply voltage is 0 V, the voltage drop $V(R_{11})$ becomes about 0.4 V. Thus, the voltage difference between the first power supply voltage $V_{CC}$ and the second power supply voltage $V_{EE1}$ can be made as small as about 2 V.

Even when the power supply voltage is low, as mentioned above, the ECL circuit $ECL_1$ can effect stable operation. First, the emitter currents of the transistors $T_{12}$, $T_{13}$ and $T_4$ are the same because the base-emitter voltage characteristics of these transistors are the same when these transistors are manufactured in the same manufacturing process. The emitter current of the transistor $T_{12}$

is equal to the current $i(R_{13})$ flowing through the resistor $R_{13}$. The base-emitter voltage $V_{BET_{12}}$ of the transistor $T_{12}$ is equal to the base-emitter voltage $V_{BET_{10}}$ of the transistor $T_{10}$. Therefore, the potential at the node $O_1$ is equal to the potential at the node N. Accordingly, the voltage $V(R_{13})$ across the resistor $R_{13}$ is equal to the emitter-base voltage $V_{EBT_{11}}$ of the PNP transistor $T_{11}$. Thus, the following expressions can be substantially obtained:

$$i(R_{13}) = V(R_{13})/R_{13} = V_{EBT_{11}}/R_{13}$$

Since $i(R_{13})$ is nearly equal to the emitter current of the transistor $T_4$ or to the emitter current of the transistor $T_{13}$, the current flowing through the transistor $T_4$ or $T_{13}$ is substantially equal to $V_{EBT_{11}}/R_{13}$, which is independent of the power supply voltage $V_{EE1}$. In other words, the node $N_c$ functions as a constant-voltage node due to the constant voltage characteristics of the forward biased PN junction and enables establishment of a desired constant current $i(R_{13})$ through the resistor $R_{13}$. Therefore, even when the power supply voltage fluctuates, the current through the transistor $T_4$ or $T_{13}$ is constant.

Second, in operation, when at least one of the inputs $A_1$ and $B_1$ is at the H level, i.e. 0 V, the transistor $T_1$ or $T_2$, or both transistors $T_1$ and $T_2$, are on, so that the above-mentioned current $V_{EBT_{11}}/R_{13}$ flows through the resistor $R_1$, resulting in an L level at the NOR output $\bar{X}_1$. The L level voltage $V_{OL\bar{X}_1}$ at the NOR output $\bar{X}_1$ is:

$$V_{OL\bar{X}_1} = -R_1 \cdot V_{BET_{11}}/R_{13}$$

When the NOR output $\bar{X}_1$ is at the L level, the transistor $T_3$ is off and the OR output $X_1$ is at an H level of 0 V.

When both inputs $A_1$ and $B_1$ are at the L level, the NOR output $\bar{X}_1$ is at the H level of 0 V and the OR output $X_1$ is at the L level of $-R_2 V_{BET_{11}}/R_{13}$.

The reference voltage $V_{BB1}$ is applied to the base of the transistor $T_3$ is expressed as:

$$V_{BB1} = -R_{12} \cdot V_{EBT_{11}}/R_{13}.$$

As mentioned before, since $R_{12} = \frac{1}{2}R_1 = \frac{1}{2}R_2$, the reference voltage $V_{BB1}$ is:

$$\begin{aligned} V_{BB1} &= -\tfrac{1}{2}R_1 \cdot V_{EBT_{11}}/R_{13} \\ &= \tfrac{1}{2}V_{OL\bar{X}_1} \\ &= \tfrac{1}{2}V_{OLX_1}. \end{aligned}$$

Thus, the reference voltage $V_{BB1}$ is half of the L level of the NOR output $\bar{X}_1$ or the OR output $X_1$. This means a maximum noise margin for the H level and the L level with respect to the reference voltage $V_{BB1}$.

Third, even when the temperature of the integrated circuit including the ECL circuit $ECL_1$ is increased, the transistors $T_1$, $T_2$, or $T_3$ are substantially prevented from being saturated. That is, when the temperature is increased, the base-collector voltage of an NPN transistor is generally decreased, so that the transistor tends to enter a saturated state. However, in the circuit of Fig. 2, the base-collector voltage of, for example, the transistor $T_1$ is $-R_1 V_{EBT_{11}}/R_{13}$ when it is in an on state. The emitter-base voltage $V_{EBT_{11}}$ of the PNP transistor $T_{11}$ is also decreased along with the increase of the temperature, because the emitter-base characteristic of the PNP transistor $T_{11}$ is similar to the base-collector characteristic of the NPN transistor $T_1$. Therefore, when the temperature is increased, not only the base-emitter voltage of the transistor $T_1$, but also the base-collector voltage of the transistor $T_1$ is decreased. Thus, the transistor $T_1$ is substantially prevented from being saturated even when the temperature is increased. A similar discussion can be applied to the transistors $T_2$ and $T_3$.

Thus, an embodiment of the present invention can assist in reducing the generation of heat in an integrated circuit by providing an improved bias circuit which can be driven in a stable manner by a relatively low power supply voltage without significant loss of switching speed as compared with the prior art.

DE—A—2941870 discloses bias circuitry (see Figure 6) which at first sight appears to have a partial similarity to the bias circuit illustrated in Figure 2, in that, for example, a diode-connected transistor has its collector connected to the base of another transistor which it itself connected between a lower voltage supply line and a current node in a chain of resistors connected to the base of a third transistor. However, this prior circuitry is principally concerned with compensating for temperature variations in a constant-current source to which the circuit provides biasing. The base to collector connections of transistor $T_{12}$ in the Figure 2 embodiment of the present invention are not to be found in Figure 6 of DE—A—2941870, nor is the forward-biased PN junction between the nodes $N_c$ and N of Figure 2 to be found in the prior Figure 6, which is accordingly of no real relevance to the present invention.

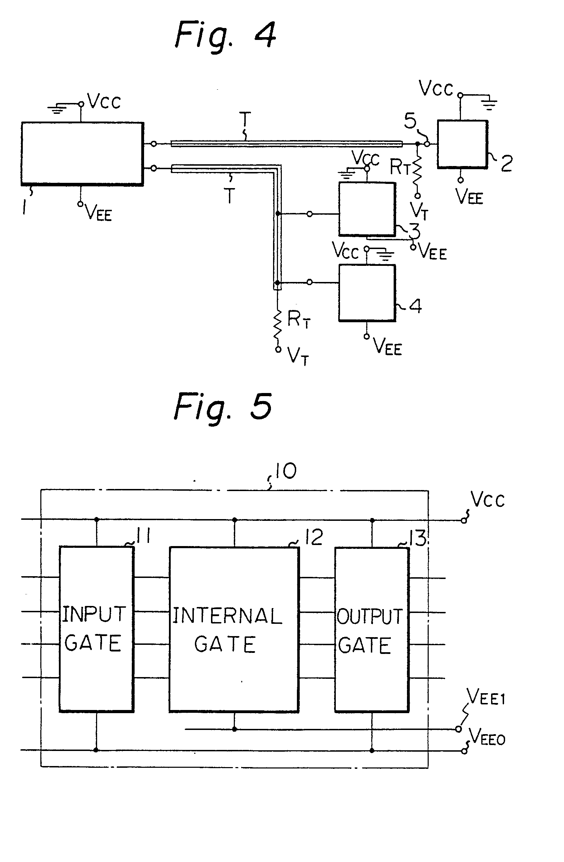

Figure 3 illustrates another embodiment of the present invention. The difference between Figs. 2 and 3 is that, in Fig. 3, resistors $R_{S1}$, $R_{S2}$, and $R_{S3}$ having small resistances are connected between the emitter of the transistor $T_4$ and the second power supply terminal $V_{EE1}$, between the emitter of the transistor $T_{13}$ and the second power supply terminal $V_{EE1}$, and between the emitter of the transistor $T_{12}$ and the power supply terminal $V_{EE1}$. Except for the above resistors $R_{S3}$, $R_{S2}$, and $R_{S1}$, the circuit configuration of Fig. 3 is the same as that of Fig. 2, and, therefore, a detailed explanation is omitted here. These small resistances function as current feedback. More precisely, even when the base-emitter voltages of the transistors $T_4$, $T_{13}$, and $T_{12}$ are made different due to the manufacturing process, the collector currents of these transistors can be made nearly equal to each other by providing these small resistances $R_{S1}$, $R_{S2}$, and $R_{S3}$. That is, these resistors are provided for decreasing current hogging of the transistors. In a practical circuit design, these small resistances may be provided. It should be noted that the output level does not substantially depend on these small resistances, i.e., the L level of the output $\overline{X}_1$ or $X_1$ is also expressed as $-R_1 V_{EBT}/R_{13}$.

It is preferable to design the L level in the range between $-200$ mV and $-450$ mV.

Figure 4 is a block diagram of an example of a system including ECL integrated circuits. In Fig. 4, reference numerals 1 through 4 are ECL integrated circuits. Each ECL integrated circuit is conventionally driven by a power supply voltage in the range of $-5.2$ V through $-4.5$ V. The ECL circuits are connected by transmission lines T to each other. Each end of the transmission lines T is connected to an end terminal 5. To each end terminal 5, an end terminal power supply voltage $V_T$ is usually applied through a resistor $R_T$ having the same impedance as the impedance of each transmission line T. The purpose of applying the end terminal power supply voltage $V_T$ through a resistor $R_T$ is to prevent signals from reflecting back to the transmission line T. This end terminal power supply voltage is usually $-2.0$ V. In the embodiments of the present invention described above, this end terminal power supply voltage is used as the second power supply voltage $V_{EE1}$ without providing a particular power supply unit for providing such a low power supply voltage.

Figure 5 is a block diagram illustrating an ECL large-scale intergrated circuit (LSI) 10. In the figure, the ECL—LSI 10 includes an input gate 11, an internal gate 12, and an output gate 13. All of these gates are connected to the first power supply terminal $V_{cc}$ to which a voltage of 0 V is applied. The input gate 11 and the output gate 13 are driven by the power supply voltage of $V_{EE0}$ in the range between $-5.2$ V and $-4.5$ V because, in these gates 11 and 13, the H level is about $-0.9$ V and the L level is about $-1.7$ V, and therefore, the logical amplitude is about 800 mV. This value of amplitude is necessary for connecting the ECL LSI 10 to another ECL circuit (not shown). In the internal gate 12, however, the logical amplitude can be made as small as about 400 mV by employing the second power supply voltage $V_{EE1}$ of $-2.0$ V. The interface between the input gate 11 and the internal gate 12 or between the internal gate 12 and the output gate 13 can be easily made. Accordingly, the bias circuit illustrated in Fig. 2 or 3 according to the embodiment of the present invention is effectively included in the internal gate 12, because, as mentioned before, the L level of the ECL circuit connected to the bias circuit of the present invention is preferably selected to be in the range between $-200$ mV and $-450$ mV.

It will be appreciated that embodiments of the present invention can be designed to provide bias voltages for circuits other than ECL circuits.

The present invention is not restricted to the above-mentioned embodiments. Various modifications are possible. For example, in place of the ECL circuit, any output means may be provided with the bias voltage produced by the bias circuit of the present invention.

## Claims

1. A bias circuit, for producing a bias voltage output $(V_{CS1})$, comprising:

a first transistor $(T_{12})$, having a base connected to one end $(O_1)$ of a first resistive device $(R_{13})$, an emitter connected to a first reference-voltage line $(V_{EE1})$, and a collector connected to the said base; and

supply means connected to the other end $(N_c)$ of the said first resistive device $(R_{13})$, for maintaining the said other end $(N_c)$ at a substantially constant voltage, which supply means include a second resistive device $(R_{11})$ having one end connected to the said other end $(N_c)$ of the said first resistive device $(R_{13})$ and having its other end connected to a second reference-voltage line $(V_{cc})$, a second transistor $(T_{10})$, having a base connected to a collector thereof and an emitter connected to the said first reference-voltage line $(V_{EE1})$, and a third resistive device $(R_{10})$ having one end connected to the said collector of the second transistor $(T_{10})$ and having its other end connected to the said second reference-voltage line $(V_{cc})$, and also include an element $(T_{11})$ having a forward-biased PN junction which is connected at one side to the said other end $(N_c)$ of the first resistive device $(R_{13})$ and at its other side to the said collector of the second transistor $(T_{10})$;

the said bias voltage output being available at the said one end $(O_1)$ of the first resistive device $(R_{13})$ when the circuit is in operation.

2. A bias circuit as claimed in claim 1, wherein the said PN junction element $(T_{11})$ comprises a third transistor, opposite in polarity to the said first transistor $(T_{12})$, having an emitter connected to the said other end $(N_c)$ of the first resistive device $(R_{13})$, having a base connected to the said base of the second transistor $(T_{10})$, and having a collector connected to the said first reference-voltage line $(V_{EEL})$.

3. A bias circuit as claimed in claim 1, wherein the said PN junction element $(T_{11})$ comprises a third transistor, opposite in polarity to the said first transistor $(T_{12})$, having an emitter connected to the said other end $(N_c)$ of the first resistive device $(R_{13})$, having a base connected to the said base of the second transistor $(T_{10})$, and having a collector connected to means for maintaining thereat a reference voltage $(V_{EE2})$, lower than that of the said first reference-voltage line $(V_{EE1})$, when the circuit is in operation.

4. A bias circuit as claimed in any preceding claim, in combination with an emitter-coupled logic circuit, the said one end $(O_1)$ of the first resistive device $(R_{13})$ being connected to a bias voltage application point of the said emitter-coupled logic circuit.

5. A combination as claimed in claim 4, wherein an additional transistor $(T_4)$, having an emitter connected to the first reference-voltage line $(V_{EE1})$ of claim 1, has its collector-emitter path connected to carry a substantially constant load current of the emitter-coupled logic circuit and has a base connected to the said bias voltage application point.

6. A combination as claimed in claim 4 or 5, wherein the said bias voltage application point is a base of a further transistor ($T_{13}$) which has an emitter connected to the first reference voltage line ($V_{EE1}$) of claim 1 and which has a collector connected through a further resistive device ($R_{12}$) to the second reference-voltage line ($V_{CC}$) of claim 1, the said collector of the further transistor ($T_{13}$) being connected to apply a logic reference voltage ($V_{BB1}$) to the emitter-coupled logic circuit.

7. A combination as claimed in claim 6, wherein the emitter-coupled logic circuit is connected between the said first and second reference-voltage lines ($V_{EE1}$, $V_{CC}$) of claim 1.

## Patentansprüche

1. Vorspannungsschaltung zur Erzeugung eines Vorspannungsausgangs ($V_{CS1}$), mit:

einem ersten Transistor ($T_{12}$), der eine Basis hat, die mit einem Ende ($O_1$) einer ersten Widerstandseinrichtung ($R_{13}$) verbunden ist, einen Emitter, der mit einer ersten Referenzspannungsleitung ($V_{EE1}$) verbunden ist, und einen Kollektor, der mit der genannten Basis verbunden ist; und

Versorgungseinrichtungen, die mit dem anderen Ende ($N_c$) der genannten ersten Widerstandseinrichtung ($R_{13}$) verbunden sind, um das genannte andere Ende ($N_c$) auf einer im wesentlichen konstanten Spannung zu erhalten, welche Versorgungseinrichtung eine zweite Widerstandseinrichtung ($R_{11}$) umfaßt, die ein Ende hat, welches mit dem genannten anderen Ende ($N_c$) der genannten ersten Widerstandseinrichtung ($R_{13}$) verbunden ist, und deren anderes Ende mit einer zweiten Referenzspannungsleitung ($V_{CC}$) verbunden ist, einem zweiten Transistor ($T_{10}$), der eine Basis hat, die mit seinem Kollektor verbunden ist, und einen Emitter, der mit der genannten ersten Referenzspannungsleitung ($V_{EE1}$) verbunden ist, und eine dritte Widerstandseinrichtung ($R_{10}$), deren eines Ende mit dem genannten Kollektor des zweiten Transistors ($T_{10}$) verbunden ist, und deren anderes Ende mit der genannten zweiten Referenzspannungsleitung ($V_{CC}$) verbunden ist, und die auch ein Element ($T_{11}$) enthalten, welches einen in Durchlaßrichtung vorgespannten PN-Übergang hat, der an einer Seite mit dem genannten anderen Ende ($N_c$) der ersten Widerstandseinrichtung ($R_{13}$), und an seiner anderen Seite mit dem genannten Kollektor des zweiten Transistors ($T_{10}$) verbunden ist;

wobei der genannte Vorspannungsausgang an dem genannten einen Ende ($O_1$) der ersten Widerstandseinrichtung ($R_{13}$) verfügbar ist, wenn die Schaltung in Betrieb ist.

2. Vorspannungsschaltung nach Anspruch 1, bei der das genannte PN-Übergangselement ($T_{11}$) einen dritten Transistor umfaßt, dessen Polarität entgegengesetzt zu derjenigen des genannten ersten Transistors ($T_{12}$) ist, der einen Emitter hat, der mit dem genannten anderen Ende ($N_c$) der ersten Widerstandseinrichtung ($R_{13}$) verbunden ist, eine Basis hat, die mit der genannten Basis des zweiten Transistors ($T_{10}$) verbunden ist, und einen Kollektor hat, der mit der genannten ersten Referenzspannungsleitung ($V_{EEL}$) verbunden ist.

3. Vorspannungsschaltung nach Anspruch 1, bei der das genannte PN-Übergangselement ($T_{11}$) einen dritten Transistor umfaßt, mit umgekehrter Polarität zu der des genannten ersten Transistors ($T_{12}$), der einen Emitter hat, der mit dem genannten anderen Ende ($N_c$) der ersten Widerstandseinrichtung ($R_{13}$) verbunden ist, eine Basis hat, die mit der genannten Basis des zweiten Transistors ($T_{10}$) verbunden ist, und einen Kollektor hat, der mit der Einrichtung zur Aufrechterhaltung einer Referenzspannung ($V_{EE2}$) an jener Stelle verbunden ist, die kleiner als diejenige der ersten Referenzspannungsleitung ($V_{EE1}$) ist, wenn die Schaltung in Betrieb ist.

4. Vorspannungsschaltung nach einem der vorhergehenden Ansprüche, in Kombination mit einer emittergekoppelten Logikschaltung, bei welcher das genannte eine Ende ($O_1$) der ersten Widerstandseinrichtung ($R_{13}$) mit einem Vorspannungs-Aufbringungspunkt der genannten emittergekoppelten Logikschaltung verbunden ist.

5. Kombination nach Anspruch 4, bei der ein zusätzlicher Transistor ($T_4$), der einen Emitter hat, der mit der ersten Referenzspannungsleitung ($V_{EE1}$) des Anspruchs 1 verbunden ist, einen Kollektor-Emitter-Weg hat, der angeschlossen ist, um einen im wesentlichen konstanten Laststrom der emitter-gekoppelten Logikschaltung zu tragen, und eine Basis hat, die mit dem genannten Vorspannungs-Aufbringungspunkt verbunden ist.

6. Kombination nach Anspruch 4 oder 5, bei der der genannte Vorspannungs-Aufbringungspunkt eine Basis eines weiteren Transistors ($T_{13}$) ist, der einen Emitter hat, der mit der ersten Referenzspannungsleitung ($V_{EE1}$) von Anspruch 1, verbunden ist, und einen Kollektor hat, der über eine weitere Widerstandseinrichtung ($R_{12}$) mit der zweiten Referenzspannungsleitung ($V_{CC}$) von Anspruch 1 verbunden ist, wobei der genannte Kollektor des weiteren Transistors ($T_{13}$) angeschlossen ist, um eine logische Referenzspannung ($V_{BB1}$) auf die emittergekoppelte Logikschaltung anzuwenden.

7. Kombination nach Anspruch 6, bei der die emittergekoppelte Logikschaltung zwischen den genannten ersten und zweiten Referenzspannungsleitungen ($V_{EE1}$, $V_{CC}$) von Anspruch 1 verbunden ist.

## Revendications

1. Circuit de polarisation destiné à produire une sortie de tension de polarisation ($V_{CS1}$), comportant:

un premier transistor ($T_{12}$) dont la base est connectée à une extrémité ($O_1$) d'un premier composant résistif ($R_{13}$), dont l'émetteur est connecté à une première ligne de tension de référence ($V_{EE1}$) et dont le collecteur est connecté à ladite base; et

un dispositif d'alimentation connecté à l'autre extrémité ($N_c$) dudit premier composant résistif ($R_{13}$) pour maintenir ladite autre extrémité à une tension pratiquement constante, ce dispositif d'alimentation comprenant un second composant résistif ($R_{11}$) dont une extrémité est connectée à ladite autre extrémité ($N_c$) dudit premier composant résistif ($R_{13}$) et dont l'autre extrémité est connectée à une seconde ligne de tension de référence ($V_{CC}$), un second transistor ($T_{10}$) dont la base est connectée à son collecteur et dont l'émetteur est connecté à ladite première ligne de tension de référence ($V_{EE1}$), et un troisième composant résistif ($R_{10}$) dont une extrémité est connectée audit collecteur du second transistor ($T_{10}$) et dont l'autre extrémité est connectée à ladite seconde ligne de tension de référence ($V_{CC}$) et comprenant également un élément ($T_{11}$) avec une jonction PN polarisée dans le sens direct qui est connectée par un côté à ladite autre extrémité ($N_c$) du premier composant résistif ($R_{13}$) et par son autre côté audit collecteur du second transistor ($T_{10}$);

ladite sortie de tension de polarisation étant disponible à ladite première extrémité ($O_1$) du premier composant résistif ($R_{13}$) quand le circuit est en fonctionnnement.

2. Circuit de polarisation selon la revendication 1, dans lequel ledit élément de jonction PN ($T_{11}$) comporte un troisième transistor de polarité opposée à celle du premier transistor ($T_{12}$), dont l'émetteur est connecté à ladite autre extrémité ($N_c$) du premier composant résistif ($R_{13}$), dont la base est connectée à ladite base du second transistor ($T_{10}$) et dont le collecteur est connecté à ladite première ligne de tension de référence ($V_{EEL}$).

3. Circuit de polarisation selon la revendication 1, dans lequel ledit élément de jonction PN ($T_{11}$) comporte un troisième transistor de polarité opposée à celle dudit premier transistor ($T_{12}$), dont l'émetteur est connecté à ladite autre extrémité ($N_c$) du premier composant résistif ($R_{13}$) dont

la base est connectée à ladite base du second transistor ($T_{10}$) et dont le collecteur est connecté au dispositif pour y maintenir une tension de référence ($V_{EE2}$) inférieure à celle de ladite première ligne de tension de référence ($V_{EE1}$) quand le circuit est en fonctionnement.

4. Circuit de polarisation selon l'une quelconque des revendications précédentes, en combinaison avec un circuit logique à couplage d'émetteur, ladite première extrémité ($O_1$) du premier composant résistif ($R_{13}$) étant connectée à un point d'application de tension de polarisation dudit circuit logique à couplage d'émetteur.

5. Combinaison selon la revendication 4, dans laquelle un transistor supplémentaire ($T_4$), ayant un émetteur connecté à la première ligne de tension de référence ($V_{EE1}$) de la revendication 1, a son circuit collecteur-émetteur connecté de manière à conduire un courant de charge pratiquement constant du circuit logique à couplage d'émetteur et dont la base est connectée audit point d'application de tension de polarisation.

6. Combinaison selon la revendication 4 ou 5, dans laquelle ledit point d'application de tension de polarisation est la base d'un autre transistor ($T_{13}$) dont l'émetteur est connecté à la première ligne de tension de référence ($V_{EE1}$) de la revendication 1, est dont le collecteur est connecté, par un autre composant résistif ($R_{12}$), à la seconde ligne de tension de référence ($V_{CC}$) de la revendication 1, ledit collecteur de l'autre transistor ($T_{13}$) étant connecté de manière à appliquer une tension de référence logique ($V_{BB1}$) au circuit logique à couplage d'émetteur.

7. Combinaison selon la revendication 6, dans laquelle le circuit logique à couplage d'émetteur est connecté entre ladite première et ladite seconde ligne de tension de référence ($V_{EE1}$, $V_{CC}$) de la revendication 1.

# 0 083 208

## Fig. 1

## Fig. 3

# Fig. 2

## Fig. 4

## Fig. 5